# EUROPÄISCHE PATENTSCHRIFT

(11) **EP 3 242 141 B1**
(45) Veröffentlichungstag und Bekanntmachung des Hinweises auf die Patenterteilung: **21.11.2018**
(21) Anmeldenummer: 17168481.4
(22) Anmeldetag: 27.04.2017
(51) Int. Cl.: G01R 33/3873, G01R 33/3815, G01R 33/28

(54) **MAGNET- UND KRYOSTATANORDNUNG SOWIE VERFAHREN ZUM PASSIVEN SHIMMEN**
MAGNETIC AND CRYOSTATIC DEVICE AND METHOD FOR PASSIVE SHIMMING
AGENCEMENT DE CRYOSTAT ET D'AIMANT ET PROCÉDÉ DE RÉGLAGE PASSIF

(30) Priorität: 06.05.2016 DE 102016207846
(43) Veröffentlichungstag der Anmeldung: 08.11.2017
(73) Patentinhaber: Bruker BioSpin GmbH, 76287 Rheinstetten (DE)
(72) Erfinder: Wikus, Patrick, 8309 Nürensdorf (CH); Niemann, Volker, 75228 Ispringen (DE); Frantz, Wolfgang, 76137 Karlsruhe (DE); Dumm, Michael, 8050 Zürich (CH); Wagenknecht, Michael, 8050 Zürich (CH); Bonn, Steffen, 8050 Zürich (CH)
(74) Vertreter: Kohler Schmid Möbus Patentanwälte

(56) Entgegenhaltungen:
- JP-A- 2005 123 230
- JP-A- 2006 311 957

## Beschreibung

Die Erfindung betrifft eine Anordnung zum Einstellen des räumlichen Verlaufs eines Magnetfelds, wobei die Anordnung eine passive Shimvorrichtung (3) mit einem oder mehreren magnetischen Feldformelementen enthält, welche dafür vorgesehen ist, in einen Kryostaten einer Magnetresonanz-Apparatur, welcher einen Hauptfeldmagneten enthält, eingesetzt und auf kryogene Temperaturen abgekühlt zu werden, wobei die Magnetresonanz-Apparatur ein Raumtemperaturrohr enthält, in welchem sich im Betrieb das Probenvolumen befindet.

Eine solche Anordnung ist bekannt aus der JP-A-2005 123230. Ähnliche Anordnungen zeigen auch die DE 199 22 652 C2 oder die DE 101 16 505 B4.

### Hintergrund der Erfindung

Die vorliegende Erfindung betrifft allgemein den Bereich der Magnetresonanz, insbesondere die Bereitstellung von hierfür geeigneten supraleitenden Magnetsystemen, die zur Erzeugung von homogenen Magnetfeldern für NMR-Messungen bestimmt sind. Die Anwendbarkeit der Erfindung ist jedoch nicht auf dieses Gebiet beschränkt.

Die Magnetresonanz (einschließlich Kernspinresonanz, abgekürzt "NMR" und einschließlich Elektronenspinresonanz, abgekürzt "EPR") ist eine weit verbreitete Messmethode, mit der chemische Verbindungen analysiert werden können. Sowohl im Bereich der Kernresonanzspektroskopie (NMR spectroscopy) als auch bei der bildgebenden Anwendung (MR imaging) wird in einem zu definierenden Probenvolumen ein sehr homogenes und zeitlich konstantes Magnetfeld benötigt, welches mit resistiven oder supraleitenden Spulen oder einer geeigneten Permanentmagnetanordnung erzeugt werden kann..

Für Anwendungen aus der Kernspinresonanz (NMR, MRI) werden Magnete benötigt, die sich unter anderem durch eine besonders hohe räumliche Homogenität des Magnetfelds im Probenraum auszeichnen. Üblicherweise werden die eingesetzten supraleitenden Magnete mit Vorrichtungen ausgestattet, die es erlauben, die Homogenität des Felds zu verstellen, um z.B. Fehler auszugleichen, die sich aus unvermeidlichen Fertigungstoleranzen ergeben.

Eine solche Vorrichtung sind z.B. "Kryoshims", d.h. supraleitende Zusatzspulen, die je nach Bedarf mit einem passend gewählten Strom geladen werden.

Eine andere Möglichkeit besteht im Einsatz von geeignet geformten Strukturen aus einem magnetischen Werkstoff (insbesondere ein ferromagnetischer Werkstoff wie z.B. Eisen, der sich im Einfluss des vom supraleitenden Magneten erzeugten Felds magnetisiert), und so für Feldkorrekturen im Probenraum genutzt werden kann.

### Spezieller Stand der Technik

Bei einigen Magnetsystemen werden "Homogenisierungstrukturen" in der Raumtemperatur-Bohrung des Magnets befestigt, wie dies etwa in den Druckschriften DE 199 22 652 C2 oder DE 101 16 505 B4 beschrieben wird.

Dies hat den Vorteil, dass die Homogenisierungsstrukturen sehr schnell ausgetauscht oder modifiziert werden können, da es nicht nötig ist, den Magneten zu entladen, aufzuwärmen, oder gar das Gehäuse des Magneten zu öffnen. Da zur Bestimmung der richtigen End-Form der Homogenisierungsstruktur typischerweise mehrere Iterationen nötig sind, vereinfacht das die Homogenisierung des Magneten drastisch.

Nachteilig wirkt sich allerdings aus, dass die Homogenisierungsstruktur zum einen gut temperiert werden muss. Durch Änderung der Sättigungsmagnetisierung des verwendeten Werkstoffs mit der Temperatur würden sich sonst auch unerwünschte Feldveränderungen ergeben. Andererseits kann nur schwer sichergestellt werden, dass es keine Relativbewegungen zwischen der supraleitenden Magnetspule und der Homogenisierungsstruktur gibt, zum Beispiel durch Vibrationen oder thermisch bedingte Längenänderungen der Aufhängung der Spule. Solche Relativbewegungen würden ebenfalls zu unerwünschten Veränderungen des Felds im Probenraum führen.

Um diese Nachteile zu vermeiden, werden die Eisenstrukturen gelegentlich auch direkt an der Magnetspule, oder zumindest am Heliumtank, in dem die Magnetspule sitzt, befestigt, wie aus der eingangs zitierten DE 199 22 652 C2 oder aus der DE 101 16 505 B4 hervorgeht.

Um die ideale Form der Homogenisierungsstruktur zu bestimmen, muss in jedem Iterationsschritt ***jedes Mal***
- das Magnetfeld vermessen,
- der Magnet entladen,
- der Kryostat auf Raumtemperatur aufgewärmt,
- der Kryostat geöffnet und belüftet,
- die Homogenisierungsstruktur modifiziert,
- der Kryostat wieder verschlossen und evakuiert,
- kryogene Flüssigkeiten eingefüllt und der Magnet abgekühlt,
- der Magnet neu geladen, und
- das Magnetfeld wieder vermessen werden.

Dieser Prozess kann, je nach Größe des Magnetsystems, *mehrere Wochen* in Anspruch nehmen, und ist mit beträchtlichen Kosten und auch Risiken (z.B. Beschädigung des Magnets durch thermisches Zyklieren) verbunden.

### Aufgabe der Erfindung

Der vorliegenden Erfindung liegt demgegenüber die Aufgabe zugrunde, in einer Anordnung der eingangs definierten Art kostengünstig und mit einfachen technischen Maßnahmen eine Feldhomogenisierung mittels einer passiven Shimvorrichtung auf eine besonders zeitsparende Weise durchzuführen, wobei gleichzeitig eine Langzeitstabilität sichergestellt sein soll.

### Kurze Beschreibung der Erfindung

Diese Aufgabe wird durch die vorliegende Erfindung auf ebenso überraschend einfache wie wirkungsvolle Weise dadurch gelöst, dass die Anordnung außerdem eine Vakuumschleuse aufweist, in welcher sich die passive Shimvorrichtung befindet und durch welche die passive Shimvorrichtung in den Kaltbereich des Kryostaten eingebracht und dort positioniert werden kann, ohne dass der Kaltbereich des Kryostaten belüftet werden muss.

Der Shim-Prozess, d.h. das Anpassen der Form der magnetischen Elemente zur verfeinerten Korrektur der Homogenität des aktuell gemessenen Magnetfelds, ist iterativ: Nach einem Einbau der magnetischen, vorzugsweise ferromagnetischen Feldformelemente in die Magnetresonanz-Apparatur wird das Magnetfeld immer wieder und solange vermessen und anhand der Ergebnisse eine optimierte Form einer neuen passiven Shimvorrichtung berechnet, bis die Homogenität des gemessenen Magnetfelds im Probenvolumen einem gewünschten Niveau entspricht. Die Verwendung einer Vakuumschleuse kann den Shim-Prozess deutlich beschleunigen, da dann das zeitaufwändige Aufwärmen und Belüften beziehungsweise Evakuieren und Abkühlen des Kryostaten zwischen den einzelnen Iterationsschritten entfallen kann.

Der erfindungsgemäße Einsatz einer Vakuumschleuse in den Kaltbereich des Kryostaten bei einer Anordnung der eingangs definierten gattungsgemäßen Art ermöglicht daher gegenüber den aus dem Stand der Technik bekannten Lösungen eine ganz erhebliche Verringerung der Zeit, die für eine -iterative-Einstellung des räumlichen Verlaufs des homogenen Magnetfelds im Probenvolumen der Magnetresonanz-Apparatur mittels einer passiven Shimvorrichtung normalerweise erforderlich ist: Anstelle eines -bisher typischen- Zeitaufwands von mehreren Wochen verringert sich die für den iterativen Shim-Prozess benötigte Zeit aufgrund der Erfindung nunmehr auf einen oder wenige Tage.

### Bevorzugte Ausführungsformen und Weiterbildungen der Erfindung

Besonders bevorzugt ist eine Ausführungsform der erfindungsgemäßen Anordnung, bei der die Vakuumschleuse in axialer Fortsetzung der im Betrieb das Raumtemperaturrohr enthaltenden Raumtemperaturbohrung an der Magnetresonanz-Apparatur an- und von dieser abmontierbar ist.
Dadurch werden keine weiteren Öffnungen im Vakuumbehälter des Kryostaten benötigt. Die existierenden Öffnungen können weiterverwendet werden.
Für den Test des Magnets reicht es aus, nur von einer Seite Zugang zum magnetischen Zentrum zu haben. Für den Einsatz beim Kunden ist es nötig, von oben und unten Zugang bzw. beiderseits bei Horizontalmagneten zum magnetischen Zentrum zu haben. Es ist daher vorteilhaft, die Vakuumschleuse demontierbar zu gestalten.

Eine weitere Ausführungsform sieht vor, dass die Vakuumschleuse ein erstes Ventil, das den Kryostaten hermetisch abschließen kann, eine Vakuumkammer und eine Pumpeinrichtung umfasst, die die Vakuumkammer, vorzugsweise über ein zweites Ventil, evakuieren oder mit Fluid befüllen oder spülen kann. Durch eine Vorrichtung zum Pumpen/Spülen können Verunreinigungen, die sich an den Oberflächen innerhalb der Vakuumschleuse festsetzen (z.B. ein dünner Film von Wassermolekülen) schneller entfernt werden. Dadurch kann das Ventil zwischen Vakuumschleuse und Kryostat früher geöffnet werden, was sich positiv auf die Testdauer auswirkt.

Besonders bevorzugt ist eine Ausführungsform, bei der innerhalb der Vakuumschleuse ein axial in Richtung der Achse der im Betrieb das Raumtemperaturrohr enthaltenden Raumtemperaturbohrung ein verfahrbarer Pressstempel angeordnet ist, mittels dessen die passive Shimvorrichtung oder Teile derselben bewegt werden können.

Vorteilhafte Weiterbildungen dieser Ausführungsform zeichnen sich dadurch aus, dass der Kryostat einen oder mehrere radial verschachtelt angeordnete Strahlungsschilde enthält, und dass am magnetseitigen Ende des Pressstempels Abdeckvorrichtungen zum Verschließen der Öffnungen in den Strahlungsschilden anbringbar sind. Durch solche Abdeckvorrichtungen wird vermieden, dass der Heliumtank einer großen Strahlungslast ausgesetzt wird. Dies minimiert den Heliumverbrauch wenn der Magnet mit der Vakuumschleuse betrieben wird. Dies hat zum einen Kostenvorteile, zum anderen vergrößert sich der Intervall, in dem Helium nachgefüllt werden kann, was die zum Test zu Verfügung stehende Zeit maximiert: Jeder Heliumtransfer stört das Gleichgewicht des Systems - nach einem Heliumtransfer kann für etwa drei Tage nicht gemessen werden.

Bei einer Klasse von Ausführungsformen der erfindungsgemäßen Anordnung enthält der Kryostat einen oder mehrere radial verschachtelt angeordnete Strahlungsschilde, wobei die passive Shimvorrichtung oder Teile derselben im Betrieb der Magnetresonanz-Apparatur mit einem oder mehreren, insbesondere mit dem radial innersten dem Raumtemperaturrohr benachbarten Strahlungsschild, vorzugsweise auf der dem Raumtemperaturrohr zugewandten Seite, wärmeleitend verbunden sind. Die Strahlungsschilde sind zumindest teilweise aktiv gekühlt, z.B. mit flüssigem Stickstoff, durch einen "Cryocooler" oder durch thermische Ankopplung an das Rohr, durch das Helium aus dem Heliumtank abdampft. Wenn nun Teile der passiven Shimvorrichtung mit einem solchen aktiv gekühlten Schild wärmeleitend verbunden sind, verringert sich die Wärmelast, die von der Wärmeleitung in der Struktur der passiven Shimvorrichtung hervorgerufen wird ("Thermal Anchoring" oder "Heat Sinking").

Bei einer Klasse von alternativen Ausführungsformen sind die passive Shimvorrichtung oder Teile derselben im Betrieb der Magnetresonanz-Apparatur im Kaltbereich des Kryostaten auf der dem Raumtemperaturrohr zugewandten Außenseite eines Heliumtanks wärmeleitend angebracht. Dadurch ergeben sich zwei Vorteile: Zum einen ist die Relativposition zwischen der Magnetspule und der Shimvorrichtung sehr genau, zum anderen ist die Shimvorrichtung keinen Temperaturschwankungen ausgesetzt. Letztere wären störend, da sich die Sättigungsmagnetisierung mit der Temperatur verändert.

Vorteilhaft ist auch eine Ausführungsform, bei der eine Zentriervorrichtung zur optimierten räumlichen Einstellung der Einbaulage der passiven Shimvorrichtung oder von Teilen derselben im Kaltbereich des Kryostaten vorgesehen ist. Dadurch wird sichergestellt, dass die Position der Shimelemente zur Magnetspule reproduzierbar hergestellt werden kann. Dies ist wichtig, damit sinnvoll iteriert werden kann, und damit die Positionierung des Eisens vor der Auslieferung des Magnets vom Hersteller zum Kunden genauso erfolgen kann, wie das im Magnettest der Fall war.

Eine bevorzugte Ausführungsform ist dadurch gekennzeichnet, dass eine Vorrichtung zur Vermessung des homogenen Magnetfelds, insbesondere des magnetischen Feldgradienten, im Probenvolumen der Magnetresonanz-Apparatur angeordnet ist, die geometrisch so gestaltet ist, dass sie durch ein offenes Ende der Raumtemperaturbohrung bis zum Probenvolumen eingeführt werden kann. Dadurch kann das Magnetfeld ohne großen Aufwand vermessen werden, was wiederum schnelle Iterationen beim Shimmen möglich macht.

Bei weiteren bevorzugten Ausführungsformen ist ein einseitig verschlossenes Raumtemperaturrohr vorgesehen, durch welches das im Betrieb der Magnetresonanz-Apparatur eingebaute durchgängig offene Raumtemperaturrohr ersetzt werden kann, insbesondere während einer Testphase der Magnetstrukturen. Durch ein solches einseitig verschlossenes Rohr kann die Vorrichtung zum Vermessen der Feldhomogenität auf einfache Art und Weise eingebracht werden. Außerdem kann in ein einseitig verschlossenes Rohr ein Probenkopf und/oder ein elektrisches RT-Shimsystem eingebaut werden, ohne dass der Zugang von der anderen Seite (für die Shimelemente) blockiert ist.

Vorzugsweise wird das einseitig verschlossene Rohr in einem Vertikalmagneten von unten eingebaut, wobei die Vakuumschleuse oben am Magnet sitzt. Dadurch ergibt sich der weitere Vorteil, dass Kondenswasser, das sich in der Bohrung bildet, nach unten heraustropfen kann. Außerdem können RT Shimsystem und Probenkopf wie üblich von unten eingebaut werden. Diese Ausführungsformen können vorteilhaft dadurch weitergebildet werden, dass mindestens zwischen zwei benachbarten, im Kaltbereich des Kryostaten angeordneten Bauteilen, insbesondere zwischen der dem Raumtemperaturrohr zugewandten Außenseite eines Heliumtanks und einem den Heliumtank umgebenden Strahlungsschild und/oder zwischen zwei benachbarten radial verschachtelt angeordneten Strahlungsschilden und/oder zwischen dem Raumtemperaturrohr und einem Strahlungsschild, Abstandshalter aus einem Material mit geringer Wärmeleitfähigkeit, vorzugsweise kleiner als 0,3 W/(m·K) bei 50 K, vorgesehen sind. Dadurch werden Berührungen zwischen Heliumtank und Strahlungsschild bzw. zwischen zwei benachbarten Strahlungsschilden oder zwischen Strahlungsschild und Raumtemperaturrohr vermieden. Solche Berührungen würden zu deutlich erhöhten Heliumverlusten führen, oder zur Ausbildung sogenannter "Cold Spots" in der RT-Bohrung, die dann wiederum zu unerwünschter Kondensation führen.

Bevorzugt ist auch eine Ausführungsform, bei der nur ein einziges, einstückig aufgebautes Feldformelement vorgesehen ist, dass das Feldformelement aus Folie und/oder Blech aufgebaut ist, dass das Feldformelement Ausnehmungen aufweist, welche in Form, Lage und Größe so gewählt sind, dass die Form und Menge des verbleibenden -magnetischen Materials bei entsprechender Positionierung der Folie und/oder des Bleches relativ zum Probenvolumen des Hauptfeldmagneten zu einem gewünschten räumlichen Verlauf des Magnetfelds im Probenvolumen des Hauptfeldmagneten führt. Eine solche integrale Struktur erlaubt besonders genaues Homogenisieren des Magnetfelds, da mit modernen Fertigungsmethoden sehr feine Formen realisiert werden können. Wenn eine dünne Folie oder ein dünnes Blech verwendet werden, ist der radiale Platzbedarf in der Bohrung sehr gering, was wiederum erlaubt, die Spalte in der Bohrung sehr klein zu halten. Dadurch wird ein überaus effizientes Magnetdesign möglich und der Innendurchmesser der innersten Wicklung kann sehr klein gehalten werden.

Wichtig für die Anwendung der vorliegenden Erfindung ist auch eine Vakuumschleuse zur Verwendung in einer Anordnung der erfindungsgemäßen Art, die sich dadurch auszeichnet, dass die Vakuumschleuse so gestaltet ist, dass die passive Shimvorrichtung oder Teile derselben nach einer Entfernung des Raumtemperaturrohres durch die Vakuumschleuse in den Kaltbereich des Kryostaten eingebracht und dort befestigt oder von dort entfernt werden können, ohne dass der Kaltbereich des Kryostaten belüftet werden muss.

In den Rahmen der vorliegenden Erfindung fällt weiterhin ein Verfahren zum Einstellen des räumlichen Verlaufs eines Magnetfelds in einem Probenvolumen eines supraleitenden Hauptfeldmagneten in einer Anordnung nach einem der vorhergehenden Ansprüche, umfassend folgende, iterativ durchzuführende Schrittfolge:
(a) Vermessung des magnetischen Felds im Probenvolumen;
(b) Einbringen oder Austausch der passiven Shimvorrichtung, deren Geometrie auf dem Ergebnis der Feldvermessung in Schritt (a) beruht, oder von Teilen derselben, durch die Vakuumschleuse in den oder aus dem Kaltbereich des Kryostaten;
(c) erneute Vermessung des magnetischen Felds im Probenvolumen. Insbesondere kann zwischen den Schritten (a) und (b) der Hauptfeldmagnet entladen und gegebenenfalls kryogenes Fluid aus dem Kaltbereich des Kryostaten abgepumpt und zwischen den Schritten (b) und (c) wieder eingefüllt und der Hauptfeldmagnet geladen werden.

Eine vorteilhafte Variante dieses Verfahrens zum Betrieb einer Anordnung mit einseitig verschlossenem Raumtemperaturrohr zeichnet sich dadurch aus, dass während der Testphase der Magnetresonanz-Apparatur ein einseitig verschlossenes Raumtemperaturrohr in der Raumtemperaturbohrung des Kryostaten eingesetzt ist, und wobei vor einer Betriebsphase der Magnetstrukturen (z.B. direkt vor der Auslieferung zum Kunden) ein durchgängig offenes Raumtemperaturrohr in die Raumtemperaturbohrung des Kryostaten eingesetzt wird.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: eine schematische räumliche, teilweise aufgeschnittene Darstellung einer Ausführungsform der erfindungsgemäßen Anordnung, bei der die Vakuumschleuse unten an einem Vertikal-Kryostaten angebracht ist;
- Fig. 2a: eine schematische, detaillierte Schnittansicht mit Einzelheiten der Positionierung der passiven Shimvorrichtung während der Testphase im Kryostaten positioniert ist sowie zusätzlich mit vergrößerten räumlichen Darstellungen einer Zentriervorrichtung;
- Fig. 2b: wie Fig. 2a, wobei jedoch die passive Shimvorrichtung im Normalbetrieb dargestellt ist;
- Fig. 3: eine schematische Schnittdarstellung einer Ausführungsform der erfindungsgemäßen Anordnung mit Magnetspule und Strahlungsschild, wobei das im Normalbetrieb vorhandene durchgängig offene Raumtemperaturrohr und in der Bohrung befindliche Strahlungsschild entfernt sind;
- Fig. 4: die Anordnung nach Fig. 3 mit einer Einrichtung zum Vermessen des Magnetfelds und unten angebrachter Vakuumschleuse;
- Fig. 5: eine schematische Schnittansicht mit Details der am Kryostaten angebauten Vakuumschleuse;
- Fig. 6: die Anordnung nach Fig. 3 mit unten angebauter Vakuumschleuse und von oben eingebrachtem einseitig verschlossenen Raumtemperaturrohr sowie einem einseitig verschlossenen Strahlungsschild in der Bohrung; und
- Fig. 7: eine Detailansicht der Abstandshalter.

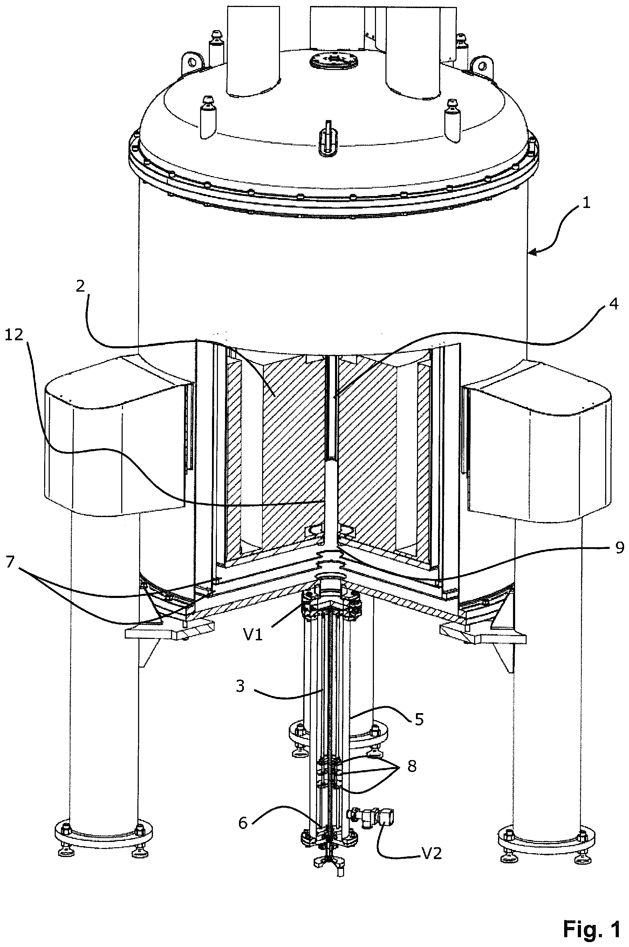

Die erfindungsgemäße Anordnung zum Einstellen des räumlichen Verlaufs eines homogenen Magnetfelds in Richtung einer **z-Achse** in einem Probenvolumen eines in einem **Kryostaten 1** angeordneten, insbesondere supraleitenden, **Hauptfeldmagneten 2**, wie sie in Fig. 1 schematisch im räumlichen Teilschnitt dargestellt ist, findet ihre Hauptanwendung als Bestandteil einer Magnetresonanz-Apparatur. Die Feinabstimmung des homogenen Magnetfelds erfolgt mittels einer **passiven Shimvorrichtung 3** mit einem oder mehreren magnetischen Feldformelementen, die im Betrieb innerhalb des Kryostaten 1 angeordnet sind und kryogene Temperaturen aufweisen, wobei die Magnetresonanz-Apparatur ein **Raumtemperaturrohr 4** enthält, in welchem sich im Betrieb das Probenvolumen befindet.

Erfindungsgemäß zeichnet sich die Anordnung dadurch aus, dass eine **Vakuumschleuse 5** vorhanden ist, durch welche die passive Shimvorrichtung 3 oder Teile derselben nach einer Entfernung des Raumtemperaturrohres 4 in den Kaltbereich des Kryostaten 1 eingebracht und dort befestigt oder von dort entfernt werden können, ohne dass der Kaltbereich des Kryostaten 1 belüftet werden muss.

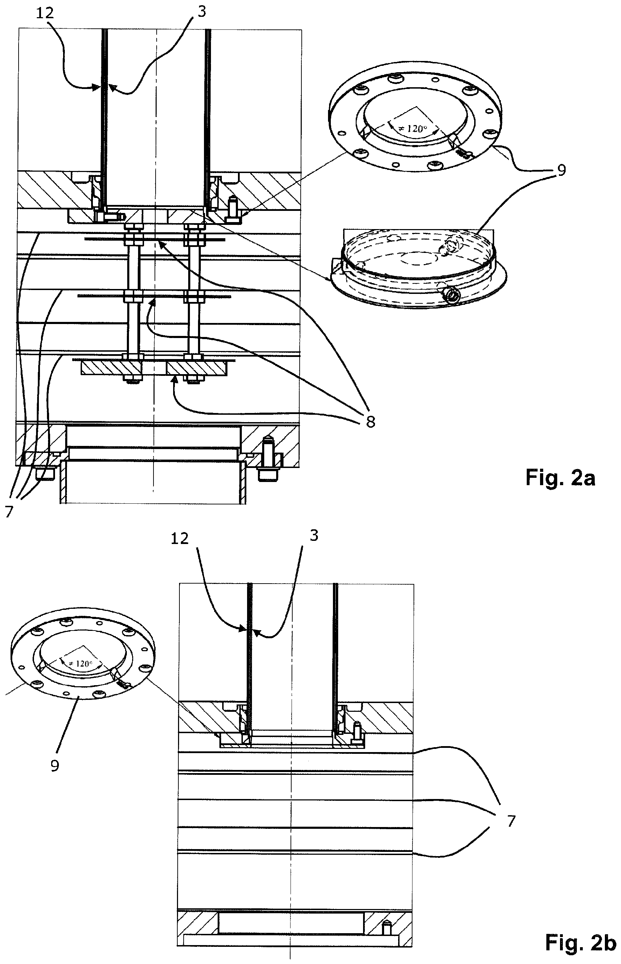

Wie in den Figuren 2a und 2b gezeigt ist, kann die Vakuumschleuse 5 in axialer Fortsetzung der im Betrieb das Raumtemperaturrohr 4 enthaltenden Raumtemperaturbohrung an der Magnetresonanz-Apparatur an- und von dieser abmontiert werden.

Die Vakuumschleuse 5 umfasst ein **erstes Ventil V1**, das den Kryostaten 1 hermetisch abschließen kann, eine Vakuumkammer und eine Pumpeinrichtung, die die Vakuumkammer über ein **zweites Ventil V2** evakuieren oder mit Fluid befüllen oder spülen kann. Zum Einbringen der Homogenisierungsstruktur in den Magneten wird die Homogenisierungsstruktur in die Vakuumkammer eingebracht und die Vakuumkammer über das zweite Ventil V2 gepumpt/gespült und evakuiert. Dann wird das erste Ventil V1 geöffnet, und die Homogenisierungsstruktur kann mittels eines geeigneten Mechanismus zum magnetischen Zentrum geschoben und dort befestigt werden.

Innerhalb der Vakuumschleuse 5 ist ein axial in Richtung der Achse der im Betrieb das Raumtemperaturrohr 4 enthaltenden Raumtemperaturbohrung ein **verfahrbarer Pressstempel 6** angeordnet, mittels dessen die passive Shimvorrichtung 3 oder Teile derselben bewegt werden können.

Der Kryostat 1 enthält einen oder mehrere radial verschachtelt angeordnete **Strahlungsschilde 7.** Am magnetseitigen Ende des Pressstempels 6 ist eine **Abdeckvorrichtung 8** zum einseitigen Verschließen der Raumtemperaturbohrungsseitigen Öffnung, insbesondere des radial innersten, dem Raumtemperaturrohr 4 benachbarten Strahlungsschildes, anbringbar.
Die Abdeckvorrichtung 8 verschließt die Öffnung im thermischen Schild und dient als Thermalisierung des Stempels, um die Wärmelast auf den Spulentank klein zu halten.

Die passive Shimvorrichtung 3 oder Teile derselben können im Betrieb der Magnetresonanz-Apparatur auf einem Strahlungsschild 7 wärmeleitend angebracht sein. Alternativ oder ergänzend können die passive Shimvorrichtung 3 oder Teile derselben im Betrieb der Magnetresonanz-Apparatur im Kaltbereich des Kryostaten 1 auf der dem Raumtemperaturrohr 4 zugewandten Außenseite eines Heliumtanks, insbesondere auf einem **Heliumtankinnenrohr 12**, wärmeleitend angebracht sein.

Des Weiteren ist eine **Zentriervorrichtung 9** zur optimierten räumlichen Einstellung der Einbaulage der passiven Shimvorrichtung 3 oder von Teilen derselben im Kaltbereich des Kryostaten 1 vorgesehen.

Weiter ist eine **Vorrichtung 10 zur Vermessung des homogenen Magnetfelds**, insbesondere des magnetischen Feldgradienten, im Probenvolumen der Magnetresonanz-Apparatur angeordnet, die geometrisch so gestaltet ist, dass sie durch ein offenes Ende der Raumtemperaturbohrung bis zum Probenvolumen eingeführt werden kann.

Für den Testbetrieb des Magneten sowie für den Versand der Anlage zum Kunden kann ein einseitig verschlossenes Raumtemperaturrohr vorgesehen sein, durch welches das im Betrieb der Magnetresonanz-Apparatur eingebaute durchgängig offene Raumtemperaturrohr 4 -zeitweise- ersetzt wird. Während der Dauer des Magnettests ist es ausreichend, die Homogenisierungsstruktur nur an den Heliumtank zu drücken, sodass durch Reibung sichergestellt wird, dass es keine Relativbewegung zwischen Spule und Homogenisierungsstruktur gibt. Dadurch entfällt die Notwendigkeit, durch die Vakuumschleuse 5 eine fixe mechanische Verbindung (z.B. mittels Schrauben) herzustellen.

Alternativ zur oben beschriebenen Variante, in der die Einrichtung 10 zur Feldvermessung in den Vakuumraum des Kryostaten 1 eingebracht wird, ist es möglich, die Raumtemperaturbohrung für die Zeit des Endtests "sacklochförmig" auszuführen. Die ist ohne weiteres machbar, da die Raumtemperaturrohre 4 (Begrenzung des Vakuumbehälters und das 80K-Rohr) einfach demontiert werden können. Für die Feldvermessung im Endtest reicht es, wenn nur von einer Seite des Magnets Zugang zum magnetischen Zentrum besteht. Wenn der Magnet im Kundenlabor installiert wird, werden die sacklochförmigen Rohre durch die gewöhnlichen Rohre ersetzt, und der beidseitige Zugang zum magnetischen Zentrum ist gegeben.

Das einseitig verschlossene Raumtemperaturrohr 4 ist durch **Abstandshalter 11** aus einem Material mit geringer Wärmeleitfähigkeit räumlich von der dem Raumtemperaturrohr zugewandten Außenseite des Heliumtanks oder einem den Heliumtank umgebenden Strahlungsschild 7 auf eine vorgegebene Distanz abgetrennt, um thermische Kurzschlüsse zwischen den sacklochförmigen Innenrohren bzw. zwischen dem 80K-Rohr und dem Heliumtank zu vermeiden.

Im Einzelnen zeigt Fig. 2a eine detaillierte schematische Schnittansicht, wie die passive Shimvorrichtung 3 beim Test im Kryostaten 1 positioniert ist, Teile mit den Strahlungsschilden 7 in thermischem Kontakt stehen und ein anderer Teil den Heliumtank am Heliumtankinnenrohr 12 kontaktiert (hier über die Zentriervorrichtung 9, die zur besseren Vorstellung auch nochmals räumlich und vergrößert gezeigt ist). Zu sehen sind die Abdeckvorrichtungen 8, die die Öffnungen in den Strahlungsschilden 7 verschließen. Wiederum ist die Vakuumschleuse 5 unten am Kryostaten 1 angebracht.

Fig. 2b zeigt eine Detailansicht, wie die passive Shimvorrichtung 3 im Normalbetrieb beim Kunden angebracht ist. Die am Heliumtank befestigte Zentriervorrichtung 9, die eine konische Fläche aufweist, dient als Aufnahme für ein passend geformtes Gegenstück an der Shimvorrichtung 3. Die Shimvorrichtung 3 ist nun direkt am Heliumtank verschraubt, und wird im Normalbetrieb nicht vom Pressstempel 6 an den Tank gedrückt.

Bei der Zentriervorrichtung 9 handelt es sich um eine konisch ausgebildete Aufnahme, die fix mit dem Heliumtank verschraubt ist, oder direkt in den Heliumtank integriert ist. Der Trägerzylinder, an dem das Eisen befestigt ist, hat ebenfalls eine konische Form (die beiden Teile passen ineinander). Durch diesen konischen Kontakt wird der Trägerzylinder in der Aufnahme am Heliumtank zentriert, wenn der Trägerzylinder vom in der Vakuumschleuse 5 befindlichen Mechanismus zum magnetischen Zentrum bewegt wird. Außerdem bietet der Konus einen "Anschlag", durch den die z-Position des Trägerzylinders (und damit des Eisens) fest definiert ist. Damit bleibt noch ein Freiheitsgrad, und zwar der der Rotation um die z-Achse. Dieser wird durch eine Ausnehmung fixiert, in die eine am Trägerzylinder befindliche "Nase" passt. Im Design können drei solcher Nasen/Ausnehmungen vorgesehen sein, die allerdings nicht um jeweils 120° versetzt sind, damit es nur eine mögliche definierte Position gibt.

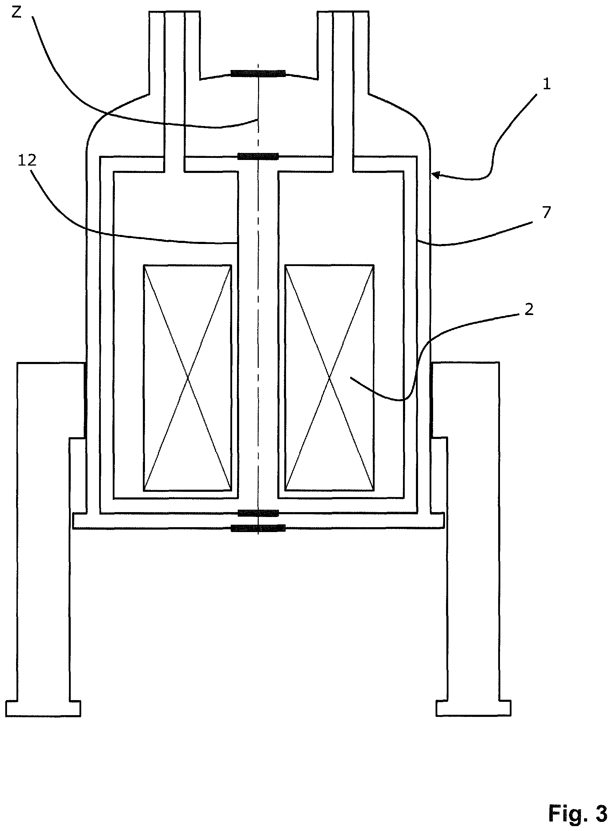

In Fig. 3 ist der Kryostat 1 mit Magnetspule 3 und Strahlungsschild 7 schematisch gezeigt, wobei das im Normalbetrieb vorhandene durchgängig offene Raumtemperaturrohr 4 und sämtliche in der Bohrung befindlichen Strahlungsschilde entfernt wurden.

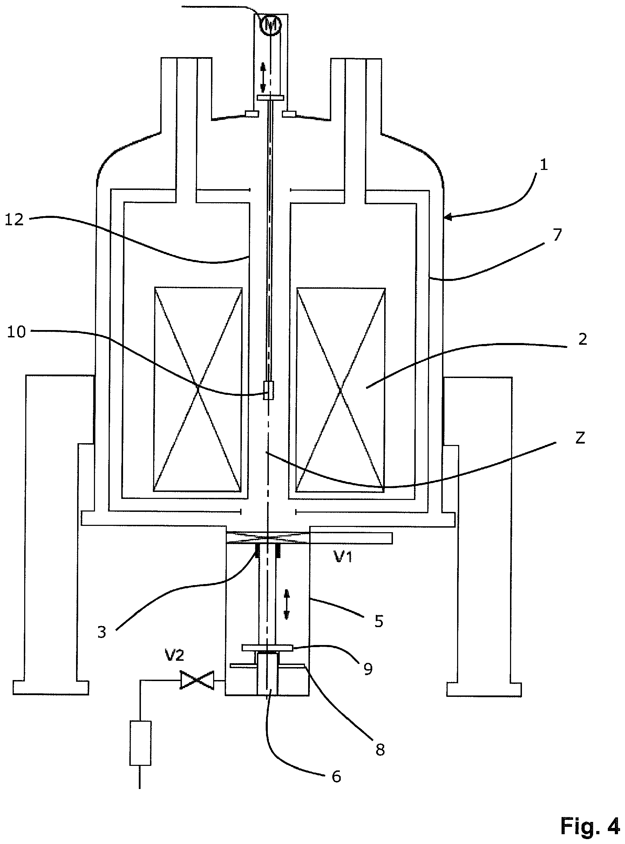

Fig. 4 zeigt den Kryostaten 1 aus Fig. 3, wobei oben eine Vorrichtung 10 zum Vermessen des Magnetfelds und unten eine Vakuumschleuse 5 angebaut sind. Die Vorrichtung 10 zum Vermessen des Magnetfelds ragt hier von oben ins Probenvolumen. Die umgekehrte Anordnung, d.h. Vakuumschleuse 5 oben und Vermessungsvorrichtung 10 unten, ist ebenfalls möglich, jedoch in der Zeichnung nicht eigens dargestellt.

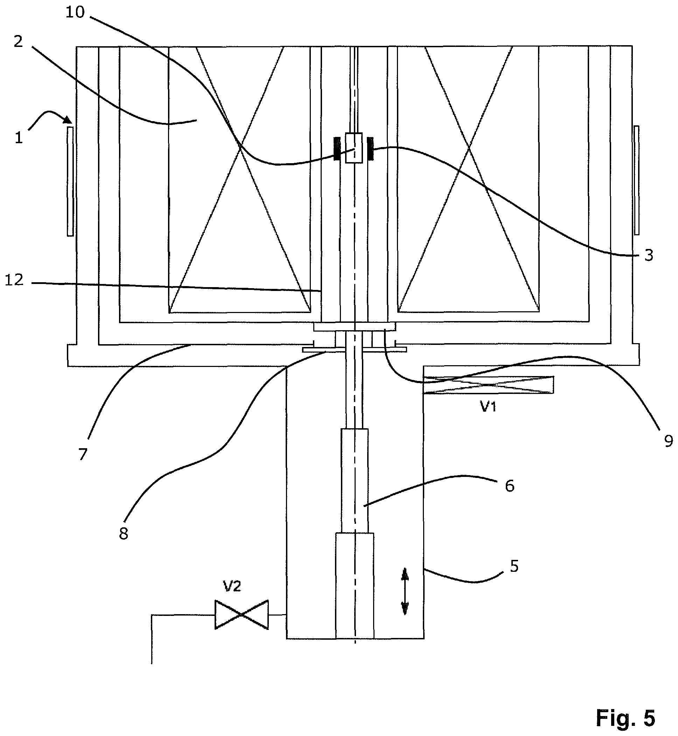

Fig. 5 zeigt eine Detailansicht der Vakuumschleuse 5 mit Ventil 1 (Verbindung zum Kryostaten-Vakuum) und Ventil 2 (zum Pumpen/Spülen). Der Pressstempel 6 hat die passive Shimvorrichtung 3 am Heliumtank positioniert; die Abdeckvorrichtung 8 verschließt die Öffnung im gezeigten Strahlungsschild 7.

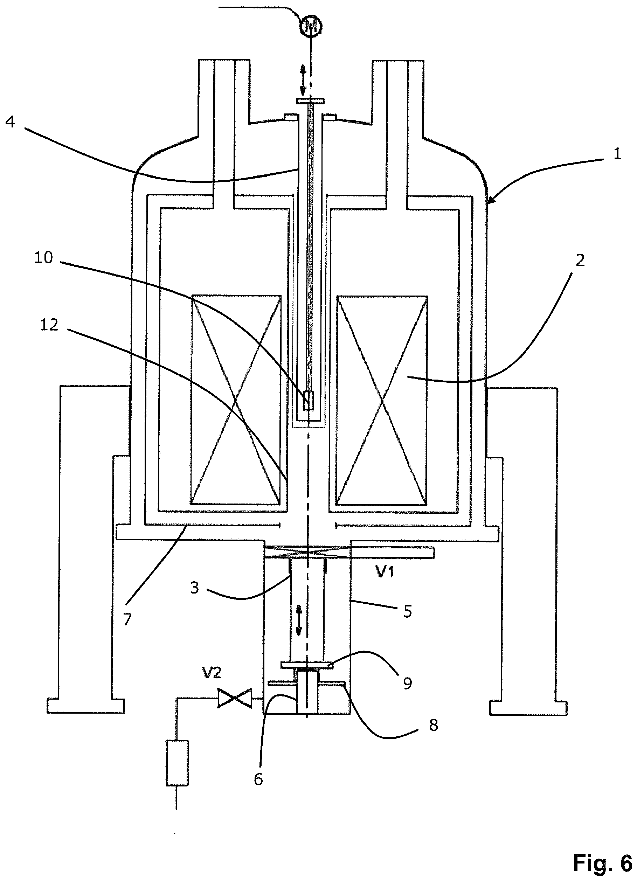

In Fig. 6 ist an den Kryostat 1 aus Fig. 3 unten eine Vakuumschleuse 5 angebaut. Von oben ist ein einseitig verschlossenes Raumtemperaturrohr 4 und ein einseitig verschlossener Strahlungsschild 7 in der Bohrung eingebaut, wobei auch hier wiederum die umgekehrte Anordnung möglich ist. Die Vorrichtung 10 zum Vermessen des Magnetfelds befindet sich dann nicht im Kryostatenvakuum, sondern kann durch das einseitig verschlossene Raumtemperaturrohr 4 ins Probenvolumen geführt werden.

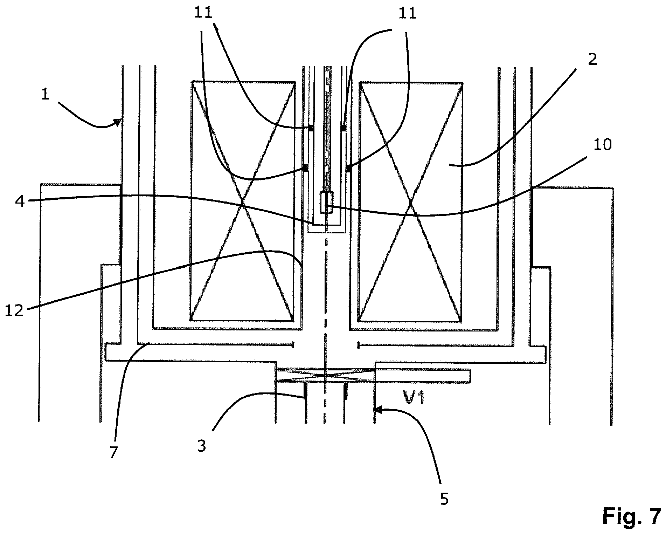

Fig. 7 schließlich zeigt eine Detailansicht der Abstandshalter 11 aus einem Material mit geringer Wärmeleitfähigkeit, die verhindern, dass sich Raumtemperaturrohr 4, Strahlungsschilde 7 oder Heliumtankrohr 12 gegenseitig berühren, was zu thermischen Kurzschlüssen und in weiterer Folge einer erhöhten Wärmelast auf die kalten Komponenten des Kryostaten 1 bzw. zur Ausbildung von Cold Spots und Kondensation im Raumtemperaturrohr 4 führen würde.

Bei in der Zeichnung nicht eigens dargestellten Ausführungsformen der Erfindung kann die passive Shimvorrichtung 3 ein, insbesondere einziges, einstückig aufgebautes Feldformelement umfassen, welches aus Folie und/oder Blech aufgebaut ist und Ausnehmungen aufweist, die in Form, Lage und Größe so gewählt sind, dass die Form und Menge des verbleibenden ferromagnetischen Materials bei entsprechender Positionierung der Folie und/oder des Bleches relativ zum Probenvolumen des Hauptfeldmagneten 2 zu einem gewünschten räumlichen Verlauf des Magnetfelds im Probenvolumen des Hauptfeldmagneten 2 führt.

Die vorliegende Erfindung kommt für alle Magnetsysteme in Frage. Für UHF NMR Magneten mit HTS-Wicklungen ist die Lösung unter Umständen besonders interessant, da die Größe der Systeme besonders lange Zeiten für die Schritte Laden/Entladen/Aufwärmen/Abkühlen erfordert und aktive Kryoshimspulen durch die abschirmende Wirkung der HTS Wicklungen ineffizient sind.

### Bezugszeichenliste:

- 1: Kryostat
- 2: Hauptfeldmagnet
- 3: passive Shimvorrichtung
- 4: Raumtemperaturrohr
- 5: Vakuumschleuse
- 6: verfahrbarer Pressstempel
- 7: Strahlungsschild(e)
- 8: Abdeckvorrichtung
- 9: Zentriervorrichtung
- 10: Vorrichtung zur Vermessung des Magnetfelds
- 11: Abstandshalter
- 12: Heliumtankinnenrohr

- V1: erstes Ventil
- V2: zweites Ventil
- z: z-Achse

## Patentansprüche

1. Anordnung zum Einstellen des räumlichen Verlaufs eines Magnetfelds, wobei die Anordnung eine passive Shimvorrichtung (3) mit einem oder mehreren magnetischen Feldformelementen enthält, welche dafür vorgesehen ist, in einen Kryostaten (1) einer Magnetresonanz-Apparatur, welcher einen Hauptfeldmagneten (2) enthält, eingesetzt und auf kryogene Temperaturen abgekühlt zu werden, wobei die Magnetresonanz-Apparatur ein Raumtemperaturrohr (4) enthält, in welchem sich im Betrieb das Probenvolumen befindet,
**dadurch gekennzeichnet,**
**dass** die Anordnung außerdem eine Vakuumschleuse (5) aufweist, in welcher sich die passive Shimvorrichtung (3) befindet und durch welche die passive Shimvorrichtung (3) in den Kaltbereich des Kryostaten (1) eingebracht und dort positioniert werden kann, ohne dass der Kaltbereich des Kryostaten (1) belüftet werden muss.

2. Anordnung nach Anspruch 1, **dadurch gekennzeichnet, dass** die Vakuumschleuse (5) in axialer Fortsetzung der im Betrieb das Raumtemperaturrohr (4) enthaltenden Raumtemperaturbohrung an der Magnetresonanz-Apparatur an- und von dieser abmontierbar ist.

3. Anordnung nach einem der vorhergehenden Ansprüche, **dadurch gekennzeichnet, dass** die Vakuumschleuse (5) ein erstes Ventil (V1), das den Kryostaten (1) hermetisch abschließen kann, eine Vakuumkammer und eine Pumpeinrichtung umfasst, die die Vakuumkammer, vorzugsweise über ein zweites Ventil (V2), evakuieren oder mit Fluid befüllen oder spülen kann.

4. Anordnung nach einem der vorhergehenden Ansprüche, **dadurch gekennzeichnet, dass** innerhalb der Vakuumschleuse (5) ein axial in Richtung der Achse der im Betrieb das Raumtemperaturrohr (4) enthaltenden Raumtemperaturbohrung ein verfahrbarer Pressstempel (6) angeordnet ist, mittels dessen die passive Shimvorrichtung (3) oder Teile derselben bewegt werden können.

5. Anordnung nach Anspruch 4, **dadurch gekennzeichnet, dass** der Kryostat (1) einen oder mehrere radial verschachtelt angeordnete Strahlungsschilde (7) enthält, und dass am magnetseitigen Ende des Pressstempels (6) eine Abdeckvorrichtung (8) zum einseitigen Verschließen der raumtemperaturbohrungsseitigen Öffnung insbesondere des radial innersten, dem Raumtemperaturrohr (4) benachbarten Strahlungsschildes (7) anbringbar ist.

6. Anordnung nach einem der vorhergehenden Ansprüche, **dadurch gekennzeichnet, dass** eine Zentriervorrichtung (9) zur optimierten räumlichen Einstellung der Einbaulage der passiven Shimvorrichtung (3) oder von Teilen derselben im Kaltbereich des Kryostaten (1) vorgesehen ist.

7. Anordnung nach einem der vorhergehenden Ansprüche, **dadurch gekennzeichnet, dass** die passive Shimvorrichtung (3) ein, insbesondere einziges, einstückig aufgebautes Feldformelement umfasst, dass das Feldformelement aus Folie und/oder Blech aufgebaut ist, dass das Feldformelement Ausnehmungen aufweist, welche in Form, Lage und Größe so gewählt sind, dass die Form und Menge des verbleibenden ferromagnetischen Materials bei entsprechender Positionierung der Folie und/oder des Bleches relativ zum Probenvolumen des Hauptfeldmagneten (2) zu einem gewünschten räumlichen Verlauf des Magnetfelds im Probenvolumen des Hauptfeldmagneten (2) führt.

8. Verfahren zum Einstellen des räumlichen Verlaufs eines Magnetfelds in einem Probenvolumen eines supraleitenden Hauptfeldmagneten (2) einer Magnetresonanz-Apparatur mit einer Anordnung nach einem der vorhergehenden Ansprüche, umfassend folgende Schritte:
(a) Vermessung des magnetischen Felds im Probenvolumen;
(b) Einbringen der passiven Shimvorrichtung (3), deren Geometrie auf dem Ergebnis der Feldvermessung in Schritt (a) beruht, oder von Teilen derselben, durch die Vakuumschleuse (5) in den oder aus dem Kaltbereich des Kryostaten (1);
(c) erneute Vermessung des magnetischen Felds im Probenvolumen.

9. Verfahren nach Anspruch 8 zum Betrieb einer Anordnung nach Anspruch 10, wobei während der Betriebsphasen der Magnetresonanz-Apparatur ein durchgängig offenes Raumtemperaturrohr (4) in der Raumtemperaturbohrung des Kryostaten (1) eingesetzt ist, und wobei vor einer Testphase des Magneten ein einseitig verschlossenes Raumtemperaturrohr in die Raumtemperaturbohrung des Kryostaten (1) eingesetzt wird.

10. Magnetresonanz-Apparatur mit einer Anordnung nach einem der Ansprüche 1 bis 7, **dadurch gekennzeichnet, dass** der Kryostat (1) einen oder mehrere radial verschachtelt angeordnete Strahlungsschilde (7) enthält, und dass die passive Shimvorrichtung (3) oder Teile derselben im Betrieb der Magnetresonanz-Apparatur auf einem, insbesondere dem radial innersten dem Raumtemperaturrohr (4) benachbarten Strahlungsschild (7), vorzugsweise auf der dem Raumtemperaturrohr (4) zugewandten Seite, wärmeleitend angebracht sind.

11. Magnetresonanz-Apparatur mit einer Anordnung nach einem der Ansprüche 1 bis 7, **dadurch gekennzeichnet, dass** die passive Shimvorrichtung (3) oder Teile derselben im Betrieb der Magnetresonanz-Apparatur im Kaltbereich des Kryostaten (1) auf der dem Raumtemperaturrohr (4) zugewandten Außenseite eines Heliumtanks wärmeleitend angebracht sind.

12. Magnetresonanz-Apparatur mit einer Anordnung nach einem der Ansprüche 1 bis 7, **dadurch gekennzeichnet, dass** die Magnetresonanz-Apparatur eine Vorrichtung (10) zur Vermessung des homogenen Magnetfelds, insbesondere des magnetischen Feldgradienten, umfasst, die im Probenvolumen der Magnetresonanz-Apparatur angeordnet und geometrisch so gestaltet ist, dass sie durch ein offenes Ende der Raumtemperaturbohrung bis zum Probenvolumen eingeführt werden kann.

13. Magnetresonanz-Apparatur mit einer Anordnung nach einem der Ansprüche 1 bis 7, **dadurch gekennzeichnet, dass** ein einseitig verschlossenes Raumtemperaturrohr vorgesehen ist, durch welches das im Betrieb der Magnetresonanz-Apparatur eingebaute durchgängig offene Raumtemperaturrohr (4) ersetzt werden kann, insbesondere während einer Testphase des Magneten.

14. Magnetresonanz-Apparatur nach Anspruch 13, **dadurch gekennzeichnet, dass** das einseitig verschlossene Raumtemperaturrohr durch Abstandshalter (11) aus einem Material mit geringer Wärmeleitfähigkeit, vorzugsweise mit einer Wärmeleitfähigkeit kleiner als 0,3 W/(m·K) bei 50 K, räumlich von der dem Raumtemperaturrohr zugewandten Außenseite des Heliumtanks oder einem den Heliumtank umgebenden Strahlungsschild (7) auf eine vorgegebene Distanz abgetrennt ist.

## Claims

1. An arrangement for setting the spatial profile of a magnetic field, wherein the arrangement contains a passive shim apparatus (3) comprising one or more magnetic field forming elements which are provided to be inserted into a cryostat (1) of a magnetic resonance installation, which contains a main field magnet (2), and to be cooled to cryogenic temperatures, wherein the magnetic resonance installation contains a room temperature tube (4), in which the sample volume is situated during operation,
**characterized in that**
the arrangement moreover comprises a vacuum lock (5) containing the passive shim apparatus (3), through which vacuum lock the passive shim apparatus (3) may be introduced into the cold region of the cryostat (1) and may be positioned there without needing to ventilate the cold region of the cryostat (1).

2. The arrangement as claimed in claim 1, **characterized in that** the vacuum lock (5) may be mounted on the magnetic resonance installation, and may be removed therefrom, in an axial continuation of the room temperature bore containing the room temperature tube (4) during operation.

3. The arrangement as claimed in any one of the preceding claims, **characterized in that** the vacuum lock (5) comprises a first valve (V1), which is able to hermetically seal the cryostat (1), a vacuum chamber and a pump device which is able to evacuate the vacuum chamber, preferably by way of a second valve (V2), or fill or purge said chamber with fluid.

4. The arrangement as claimed in any one of the preceding claims, **characterized in that** a displaceable ram (6) is arranged axially in the direction of the axis of the room temperature bore containing the room temperature tube (4) during operation within the vacuum lock (5), the passive shim apparatus (3) or parts of same being able to be moved by means of said ram.

5. The arrangement as claimed in claim 4, **characterized in that** the cryostat (1) contains one or more radiation shields (7) arranged in a radially nested manner and that a cover apparatus (8) for one-sided sealing of the opening on the side of the room temperature bore is attachable to the magnet-side end of the ram (6), in particular for one-sided sealing of the radially innermost radiation shield (7) adjacent to the room temperature tube (4).

6. The arrangement as claimed in any one of the preceding claims, **characterized in that** a centering device (9) is provided for optimized spatial setting of the installation position of the passive shim apparatus (3) or of parts of same in the cold region of the cryostat (1).

7. The arrangement as claimed in any one of the preceding claims, **characterized in that** the passive shim apparatus (3) comprises a field forming element, in particular a single field forming element, with an integral design, that the field forming element is constructed from a film and/or sheet, that the field forming element comprises recesses which are selected in terms of form, position and size in such a way that the form and amount of the remaining ferromagnetic material leads to a desired spatial profile of the magnetic field in the sample volume of the main field magnet (2) in the case of appropriate positioning of the film and/or of the sheet relative to the sample volume of the main field magnet (2).

8. A method for setting the spatial profile of a magnetic field in a sample volume of a superconducting main field magnet (2) of a magnetic resonance installation comprising an arrangement as claimed in any one of the preceding claims, comprising the following steps:
(a) measuring the magnetic field in the sample volume;
(b) introducing or removing the passive shim apparatus (3), the geometry of which is based on the result of the field measurement in step (a), or of parts of same into or from the cold region of the cryostat (1) through the vacuum lock (5);
(c) measuring the magnetic field in the sample volume again.

9. The method as claimed in claim 8 for operating an arrangement as claimed in claim 10, wherein, during the operating phases of the magnetic resonance installation, a room temperature tube (4) which is open throughout is inserted into the room temperature bore of the cryostat (1) and wherein a room temperature tube which is sealed on one side is introduced into the room temperature bore of the cryostat (1) prior to a testing phase of the magnet.

10. A magnetic resonance installation comprising an arrangement as claimed in any one of the claims 1 to 7, **characterized in that** the cryostat (1) contains one or more radiation shields (7) arranged in a radially nested manner and that the passive shim apparatus (3) or parts of same are attached in a heat conducting manner to a radiation shield (7), in particular to the radially innermost radiation shield adjacent to the room temperature tube (4), preferably on the side facing the room temperature tube (4), during operation of the magnetic resonance installation.

11. The magnetic resonance installation comprising an arrangement as claimed in any one of the claims 1 to 7, **characterized in that** the passive shim apparatus (3) or parts of same are attached in a heat conducting manner in the cold region of the cryostat (1) on the outer side of a helium tank facing the room temperature tube (4) during operation of the magnetic resonance installation.

12. The magnetic resonance installation comprising an arrangement as claimed in any one of the claims 1 to 7, **characterized in that** the magnetic resonance installation comprises an apparatus (10) for measuring the homogeneous magnetic field, in particular the magnetic field gradient, which is arranged in the sample volume of the magnetic resonance installation and has such a geometric design that it may be introduced as far as the sample volume through an open end of the room temperature bore.

13. The magnetic resonance installation comprising an arrangement as claimed in any one of the claims 1 to 7, **characterized in that** provision is made of a room temperature tube which is sealed on one side and which may be used, in particular during a test phase of the magnet, to replace the room temperature tube (4) which is open throughout and installed during operation of the magnetic resonance installation.

14. The magnetic resonance installation according to claim 13, **characterized in that**, by way of spacer elements (11) made of a material with a low thermal conductivity, preferably with a thermal conductivity of less than 0.3 W/(m·K) at 50 K, the room temperature tube which is sealed on one side is spatially separated by a predetermined distance from the external side of the helium tank facing the room temperature tube or from a radiation shield (7) surrounding the helium tank.

## Revendications

1. Agencement pour régler la distribution spatiale d'un champ magnétique, l'agencement contenant un dispositif de correction passif (3) comportant un ou plusieurs éléments de formation de champ magnétique prévus pour être montés dans un cryostat (1) d'un appareil à résonance magnétique contenant un aimant de champ principal (2) et être refroidis à des températures cryogéniques, l'appareil à résonance magnétique contenant un tube à température ambiante (4) dans lequel le volume d'échantillon se trouve pendant le fonctionnement,
**caractérisé en ce**
**que** l'agencement présente en outre un sas à vide (5) dans lequel se trouve le dispositif de correction passif (3) et à travers lequel le dispositif de correction passif (3) peut être introduit dans la zone froide du cryostat (1) et y être positionné sans que la zone froide du cryostat (1) ne doive être ventilée.

2. Agencement selon la revendication 1, **caractérisé en ce que** le sas à vide (5) peut être monté sur l'appareil à résonance magnétique et démonté de celui-ci dans le prolongement axial de l'alésage à température ambiante contenant le tube à température ambiante (4) pendant le fonctionnement.

3. Agencement selon l'une des revendications précédentes, **caractérisé en ce que** le sas à vide (5) comprend une première vanne (V1) qui peut fermer hermétiquement le cryostat (1), une chambre à vide et un dispositif de pompage qui peut faire le vide dans la chambre à vide, la remplir ou la rincer avec du fluide, de préférence via une deuxième vanne (V2).

4. Agencement selon l'une des revendications précédentes, **caractérisé en ce qu'**un piston presseur (6) mobile axialement dans la direction de l'axe de l'alésage à température ambiante contenant le tube à température ambiante (4) pendant le fonctionnement est disposé à l'intérieur du sas à vide (5), au moyen duquel le dispositif de correction passif (3) ou des parties de celui-ci peut/peuvent être déplacé(es).

5. Agencement selon la revendication 4, **caractérisé en ce que** le cryostat (1) contient un ou plusieurs écrans de rayonnement (7) imbriqués radialement, et qu'un dispositif de recouvrement (8) peut être fixé à l'extrémité côté aimant du piston presseur (6) pour fermer d'un côté l'ouverture côté alésage à température ambiante, en particulier de l'écran de rayonnement (7) le plus intérieur radialement, adjacent au tube à température ambiante (4).

6. Agencement selon l'une des revendications précédentes, **caractérisé en ce qu'**un dispositif de centrage (9) est prévu pour le réglage spatial optimisé de la position de montage du dispositif de correction passif (3) ou de parties de celui-ci dans la zone froide du cryostat (1).

7. Agencement selon l'une des revendications précédentes, **caractérisé en ce que** le dispositif de correction passif (3) comprend un, en particulier un seul élément de formation de champ constitué d'une seule pièce, que l'élément de formation de champ est réalisé en film et/ou en tôle, que l'élément de formation de champ présente des évidements dont la forme, la position et la taille sont choisies de telle sorte que la forme et la quantité du matériau ferromagnétique restant, lorsque le film et/ou la tôle est positionné de façon correspondante par rapport au volume d'échantillon de l'aimant de champ principal (2), conduisent à une distribution spatiale souhaitée du champ magnétique dans le volume d'échantillon de l'aimant de champ principal (2).

8. Procédé pour régler la distribution spatiale d'un champ magnétique dans un volume d'échantillon d'un aimant de champ principal supraconducteur (2) d'un appareil à résonance magnétique doté d'un agencement selon l'une des revendications précédentes, comprenant les étapes suivantes :
(a) mesure du champ magnétique dans le volume d'échantillon ;
(b) introduction du dispositif de correction passif (3), dont la géométrie est basée sur le résultat de la mesure de champ à l'étape (a), ou de parties de celui-ci, à travers le sas à vide (5) dans la zone froide du cryostat (1) ou hors de celle-ci ;
c) nouvelle mesure du champ magnétique dans le volume d'échantillon.

9. Procédé selon la revendication 8 pour faire fonctionner un agencement selon la revendication 10, dans lequel, pendant les phases de fonctionnement de l'appareil à résonance magnétique, un tube à température ambiante (4) ouvert de bout en bout est inséré dans l'alésage à température ambiante du cryostat (1), et dans lequel, avant une phase de test de l'aimant, un tube à température ambiante fermé d'un côté est inséré dans l'alésage à température ambiante du cryostat (1).

10. Appareil à résonance magnétique doté d'un agencement selon l'une des revendications 1 à 7, **caractérisé en ce que** le cryostat (1) contient un ou plusieurs écrans de rayonnement (7) imbriqués radialement, et que le dispositif de correction passif (3) ou des parties de celui-ci sont fixés, pendant le fonctionnement de l'appareil à résonance magnétique, de manière thermoconductrice sur un écran de rayonnement (7), en particulier le plus intérieur radialement, adjacent au tube à température ambiante (4), de préférence sur le côté tourné vers le tube à température ambiante (4).

11. Appareil à résonance magnétique doté d'un agencement selon l'une des revendications 1 à 7, **caractérisé en ce que** le dispositif de correction passif (3) ou des parties de celui-ci sont fixés, pendant le fonctionnement de l'appareil à résonance magnétique, dans la zone froide du cryostat (1) de manière thermoconductrice sur le côté extérieur d'un réservoir d'hélium tourné vers le tube à température ambiante (4).

12. Appareil à résonance magnétique doté d'un agencement selon l'une des revendications 1 à 7, **caractérisé en ce que** l'appareil à résonance magnétique comprend un dispositif (10) pour mesurer le champ magnétique homogène, en particulier le gradient de champ magnétique, qui est disposé dans le volume d'échantillon de l'appareil à résonance magnétique et est réalisé géométriquement de manière à pouvoir être introduit jusqu'au volume d'échantillon par une extrémité ouverte de l'alésage à température ambiante.

13. Appareil à résonance magnétique doté d'un agencement selon l'une des revendications 1 à 7, **caractérisé en ce qu'**il est prévu un tube à température ambiante fermé d'un côté, par lequel le tube à température ambiante (4) ouvert de bout en bout monté pendant le fonctionnement de l'appareil à résonance magnétique peut être remplacé, en particulier pendant une phase de test de l'aimant.

14. Appareil à résonance magnétique selon la revendication 13, **caractérisé en ce que** le tube à température ambiante fermé d'un côté est séparé spatialement d'une distance prédéfinie du côté extérieur du réservoir d'hélium tourné vers le tube à température ambiante ou d'un écran de rayonnement (7) entourant le réservoir d'hélium par des entretoises (11) constituées d'un matériau à faible conductivité thermique, de préférence ayant une conductivité thermique inférieure à 0,3 W/(m·K) à 50 K.
